# EUROPEAN PATENT APPLICATION

(11) **EP 4 418 311 A1**
(43) Date of publication of application: **21.08.2024**
(21) Application number: 24150695.5
(22) Date of filing: 08.01.2024
(51) Int. Cl.: H01L 21/768, H01L 23/48, H01L 23/528, H01L 23/535, H01L 25/07

(54) **INTEGRATED CIRCUIT DEVICE**

(30) Priority: 27.01.2023 KR 20230011119
(71) Applicant: Samsung Electronics Co., Ltd., Suwon-si, Gyeonggi-do 16677 (KR)
(72) Inventor: PARK, Juneyoung, 16677 Suwon-si (KR); SHIN, Heonjong, 16677 Suwon-si (KR); JANG, Jaeran, 16677 Suwon-si (KR); LEE, Doohyun, 16677 Suwon-si (KR)
(74) Representative: Marks & Clerk LLP

(57) **Abstract**

An integrated circuit device includes a first substrate having a first surface and a second surface opposite to the first surface, and including an active device therein, a first back end of layer (BEOL) structure disposed on the first surface of the first substrate and configured to route signals, a second substrate disposed on the first surface of the first substrate with the first BEOL structure disposed therebetween, and including a passive device therein, a power distribution structure disposed on the second surface of the first substrate, a first bonding structure positioned on the first BEOL structure, and a second bonding structure disposed between the first bonding structure and the second substrate.

## Description

### BACKGROUND

The inventive concept relates to a backside power distribution network (BSPDN) integrated circuit device, and more particularly, to an integrated circuit device in which an active device and a passive device are provided on different substrates.

A BSPDN semiconductor architecture separates signal wires from a power distribution network (PDN) provided on a substrate, by providing a semiconductor device, such as an integrated circuit, including the signal wires and active devices for signal routing on a front side of the substrate, and providing a PDN for power supply on a rear side of the substrate. The BSPDN semiconductor architecture may minimize routing congestion and scale down an area of a semiconductor architecture. The BSDPN semiconductor architecture may result in an area reduction and an improved current-resistance (IR) drop compared to a general PDN architecture.

### SUMMARY

The inventive concept provides an integrated circuit device in which a process difficulty of a power distribution network (PDN) for power supply is reduced, by separating a substrate provided with an active device from a substrate provided with a passive device.

The problems of the inventive concept are not limited to the problems mentioned above, and other problems not mentioned will be clearly understood by those skilled in the art from the description below.

According to an aspect of the inventive concept, there is provided an integrated circuit device including a first substrate having a first surface and a second surface opposite to the first surface, and including an active device therein, a first back end of layer (BEOL) structure on the first surface of the first substrate and configured to route signals, a second substrate on the first surface of the first substrate with the first BEOL structure therebetween, and including a passive device therein, a power distribution structure on the second surface of the first substrate, a first bonding structure positioned on the first BEOL structure, and a second bonding structure between the first bonding structure and the second substrate, wherein an upper surface of the second bonding structure contacts an upper surface of the first bonding structure to form an interface with the first bonding structure, and the second bonding structure and the first bonding structure are positioned between the first substrate and the second substrate. According to another aspect of the inventive concept, there is provided an integrated circuit device including a first bonding structure, a second bonding structure contacting an upper surface of the first bonding structure to form an interface, a first device region defined in one direction with respect to the upper surface, and a second device region defined in a direction opposite to the one direction with respect to the upper surface, wherein the first device region includes a first substrate having a first surface and a second surface opposite to the first surface, and including an active device therein, a first back end of layer (BEOL) structure on the first surface of the first substrate and configured to route signals, a power distribution structure on the second surface of the first substrate, and a through via passing through the first device region and the second bonding structure and configured to transfer an electrical signal to the second device region, wherein the second device region includes a second substrate including a passive device, and the first substrate does not include the passive device.

According to another aspect of the inventive concept, there is provided an integrated circuit device including a first bonding structure, a second bonding structure contacting an upper surface of the first bonding structure to form an interface, a first device region defined in one direction with respect to the upper surface, and a second device region defined in a direction opposite to the one direction with respect to the upper surface, wherein the first device region includes a first substrate having a first surface and a second surface opposite to the first surface, and including an active device therein, a first back end of layer (BEOL) structure disposed on the first surface of the first substrate, configured to route signals received from or transferred to the active device, and including first BEOL distribution patterns having different vertical levels and first BEOL vias between the first BEOL distribution patterns, a power distribution structure on the second surface of the first substrate and configured to supply power to the active device, including power distribution patterns having different vertical levels, and power distribution vias between the power distribution patterns, and a power pad below the power distribution structure and configured to supply power to the active device, wherein the second device region includes a second substrate including a passive device therein and having a thickness greater than a thickness of the first substrate in a direction perpendicular to an upper surface of the first substrate.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a perspective view illustrating an integrated circuit device, according to an embodiment;
FIG. 2 is a block diagram illustrating an integrated circuit device including a power gating circuit, according to an embodiment;
FIG. 3 is a cross-sectional view taken along line I-I' of FIG. 1;
FIG. 4 is a cross-sectional view corresponding to FIG. 3 in an integrated circuit device, according to another embodiment;
FIG. 5 is a cross-sectional view corresponding to FIG. 3 in an integrated circuit device, according to another embodiment;
FIG. 6 is a cross-sectional view corresponding to FIG. 3 in an integrated circuit device, according to another embodiment;
FIG. 7 is a flowchart illustrating a manufacturing process for an integrated circuit device, according to an embodiment;
FIGS. 8 to 13 are cross-sectional views sequentially illustrating a manufacturing process for an integrated circuit device, according to an embodiment;
FIG. 14 is a block diagram illustrating a system on chip (SoC) according to an embodiment; and
FIG. 15 is a block diagram illustrating a computing system including a memory storing a program, according to an embodiment.

### DETAILED DESCRIPTION OF THE EMBODIMENTS

Hereinafter, embodiments of the inventive concept will be described in detail with reference to the accompanying drawings. However, the inventive concept may be embodied in various other forms.

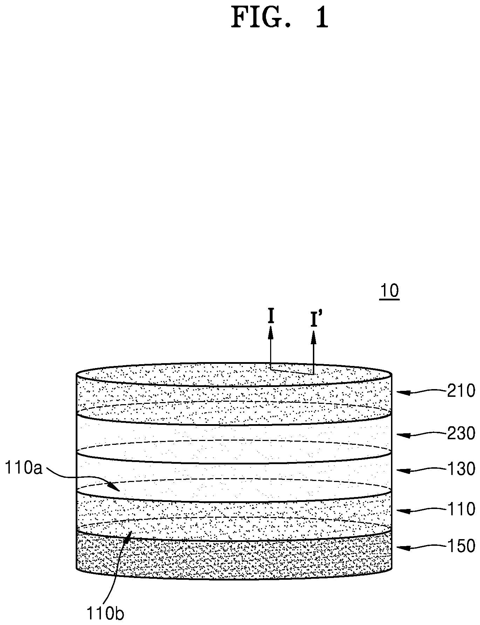

FIG. 1 is a perspective view illustrating an integrated circuit device, according to an embodiment.

As shown in FIG. 1, an integrated circuit device 10 may include a first substrate 110, a second substrate 210 provided on a first surface 110a of the first substrate 110, and a power distribution structure 150 provided on a second surface 110b of the first substrate 110. The first substrate 110 and the power distribution structure 150 may be integrated with each other and form a backside power distribution network (BSPDN), according to an embodiment. The power distribution structure 150 can be electrically connected to the first substrate 110.

The first substrate 110 may include, for example, a silicon substrate, a glass substrate, or a sapphire substrate. However, embodiments are not limited thereto. As shown in FIG. 1, the first substrate 110 may be a circular panel, but the shape of the first substrate 110 is not limited thereto. For example, the first substrate 110 may be a rectangular panel. The first substrate 110 may include a single layer or multiple layers. The first substrate 110 can have a first surface 110a and a second surface 110b opposite the first surface with a thickness therebetween.

According to an embodiment, a plurality of bonding structures 130 and 230 may be disposed between the first surface 110a of the first substrate 110 and the second substrate 210. The plurality of bonding structures 130 and 230 may electrically connect the power distribution structure 150 and devices of the first substrate 110 to devices of the second substrate 210. This will be described in detail with reference to the drawings.

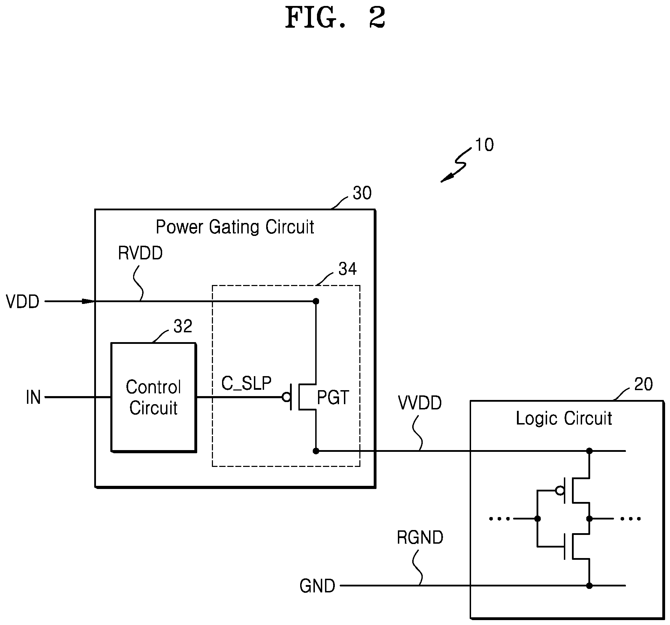

FIG. 2 is a block diagram illustrating an integrated circuit device including a power gating circuit according to an embodiment.

Referring to FIG. 2, the integrated circuit device 10 may include a logic circuit 20 and a power gating circuit 30 that can provide power to the logic circuit 20. The logic circuit 20 may be connected to a first virtual power line WDD and a second power line RGND, and receive power through the first virtual power line WDD and the second power line RGND. In an embodiment, the second power line RGND may be a ground line, and a ground voltage GND may be applied to the logic circuit 20 through the second power line RGND.

In an embodiment, the integrated circuit device 10 may be a system-on-chip (SoC). For example, the integrated circuit device 10 may be a mobile SoC, an application processor, a media processor, a microprocessor, a central processing unit (CPU), or a similar device.

The power gating circuit 30 may be connected to a first power line RVDD that can provide a power voltage VDD to the power gating circuit 30. The power gating circuit 30 may adjust a first driving voltage provided to the logic circuit 20 and adjust a power mode of the logic circuit 20, by selectively connecting the first power line RVDD to the first virtual power line VVDD in response to a control signal IN.

For example, the power gating circuit 30 may provide the power voltage VDD to the logic circuit 20 by connecting the first power line RVDD to the first virtual power line WDD in a power-on mode, and the power gating circuit 30 may cause the first virtual power line WDD to be floating by disconnecting the first power line RVDD and the first virtual power line WDD from each other in a power-off mode.

The integrated circuit device 10 may further include a power management circuit external to the power gating circuit 30, where a control signal IN may be provided from the power management circuit to the power gating circuit 30. The power management circuit may apply the control signal IN to the power gating circuit 30, so that a voltage level provided to the logic circuit 20 varies according to a power mode, where the power mode can be based on the control signal IN.

The logic circuit 20 may selectively receive power through the first virtual power line WDD. The logic circuit 20 may receive a first driving voltage of a different level according to the power mode. For example, the logic circuit 20 may receive the power voltage VDD in the power-on mode, and may be powered off in the power-off mode. In FIG. 2, the integrated circuit device 10 is driven in the power-on mode and the power-off mode, but unlike this, the integrated circuit device 10 may be configured to be further driven in one or more retention modes in addition to the power-on mode and the power-off mode.

The logic circuit 20 may include a circuit connected to the first virtual power line WDD, where for example, the logic circuit 20 may be implemented as an inverter, a NAND gate, an AND gate, an NOR gate, an OR gate, an XOR gate, an XNOR gate, a multiplexer, an adder, a latch, a flip-flop, etc.

The power gating circuit 30 may include a sleep control transistor unit 34 connected between the first power line RVDD and the first virtual power line WDD and a control circuit 32 providing switching signals C_SLP to the sleep control transistor unit 34. In some embodiments, the power gating circuit 30 may not include the control circuit 32, and the sleep control transistor unit 34 may directly receive the switching signals C_SLP from the outside of the power gating circuit 30, where a control signal IN may be directly connected to the sleep control transistor unit 34. In some embodiments, the sleep control transistor unit 34 may include a sleep control transistor PGT. The control signal IN may be directly provided to the sleep control transistor PGT.

In various embodiments, in the power-on mode, the control circuit 32 may generate the switching signal C_SLP of a logic low level for turning on the sleep control transistor unit 34, and providing the first virtual power line VVDD from the sleep control transistor unit 34 to the logic circuit 20 by the switching signal C_SLP. In the power-off mode, the control circuit 32 may generate the switching signal C_SLP of a logic high level for turning off the sleep control transistor unit 34, the sleep control transistor unit 34 may be turned off by the switching signal C_SLP, and the first virtual power line VVDD may be disconnected from the first power line RVDD to be floating.

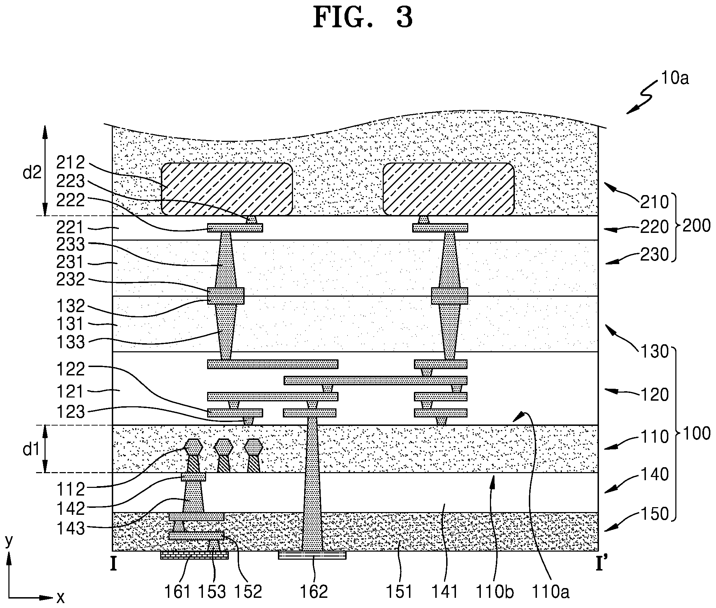

FIG. 3 is a cross-sectional view taken along line I-I' of FIG. 1.

Referring to FIG. 3, an integrated circuit device 10a according to an embodiment may include the first substrate 110 including the first surface 110a, the second surface 110b opposite to the first surface 1 10a, and an active device 112 therein. The active device 112 may be provided on a front-end-of-line (FEOL) layer of the first substrate 110. The active device 112 may be a multibridge channel field effect transistor (MBCFET) device. However, the inventive concept is not limited thereto, and the active device 112 may include a planar FET device, a gate-all-around type FET device, a two-dimensional (2D) material based FET device such as an MoS₂ semiconductor gate electrode, etc. According to an embodiment, the first substrate 110 may include only the active device 112 and may not include a passive device 212.

As shown in FIG. 3, the integrated circuit device 10a may include the first bonding structure 130 and the second bonding structure 230 that contacts an upper surface of the first bonding structure 130 to form an interface. The first bonding structure 130 and the second bonding structure 230 may extend in a first direction (x direction). The first direction (x direction) may be a horizontal direction. That is, the first direction may be parallel to one or both of the first surface 110a and second surface 110b. A second direction (y direction) may be defined as a vertical direction perpendicular to the first direction (x direction). The second direction (y direction) may refer to a direction in which the first bonding structure 130 and the second bonding structure 230 are bonded and stacked. The second direction (y direction) may be perpendicular to one or both of the first surface 110a and second surface 110b.

The integrated circuit device 10a may include a first device region 100 and a second device region 200 separated from the first device region 100. The first device region 100 may include a first substrate 110, a first BEOL structure 120, a first bonding structure 130, an intermediate structure 140, and a power distribution structure 150. The second device region 200 may include a second substrate 210, a second BEOL structure 220, and a second bonding structure 230.

The second device region 200 may be defined in the second direction (y direction) with respect to the upper surface of the first bonding structure 130. With reference to the second device region 200, terms such as "upper", "lower", "above", "below", etc. may be based on taking a direction opposite to the second direction (y direction) as a height direction. Accordingly, an "upper surface" of the second bonding structure 230 may be a surface of the second bonding structure 230 that is furthest along the height direction of the second device region 200 (the direction opposite to the second direction (y direction)). The first device region 100 may be defined in a direction opposite to the second direction (y direction) based on the upper surface of the first bonding structure 130. With reference to the first device region 100, terms such as "upper", "lower", "above", "below", etc. may be based on taking the second direction (y direction) as a height direction. Accordingly, an "upper surface" of the first bonding structure 130 may be a surface of the first bonding structure 130 that is furthest along the height direction of the first device region 100 (the second direction (y direction)). It will be appreciated that these terms are relative to the structure of the integrated circuit device 10a. Accordingly, such as "upper", "lower", "above", "below", etc. are relative terms (e.g. relative to the structure of the integrated circuit device 10a) and need not imply any particular orientation of the integrated circuit device 10a in use. A thickness of the first substrate 110 may be less than a thickness of the first bonding structure 130 in a direction (e.g. the second direction) perpendicular to the first surface 110b of the first substrate 110. A first device region 100 can be defined in one direction with respect to the upper surface, and a second device region 200 can be defined in a direction opposite to the one direction with respect to the upper surface, where the first device region 100 can include a first substrate 110 and the second device region 200 can include a second substrate 210. That is, a height direction of the first device region 100 may be opposite to a height direction of the second device region 200.

The first device region 100 may include the first substrate 110 including the active device 112. The first substrate 110 may include a semiconductor material, for example, a Group IV semiconductor material, a Group III-V semiconductor material, a Group II-VI semiconductor material, or a combination thereof. The Group IV semiconductor material may include, for example, silicon (Si), germanium (Ge), or a combination thereof. The Group III-V semiconductor material may include, for example, gallium arsenide (GaAs), indium phosphide (InP), gallium phosphide (GaP), indium arsenide (InAs), indium antimony (InSb), indium gallium arsenide (InGaAs), or a combination thereof. The Group II-VI semiconductor material may include, for example, zinc telluride (ZnTe), cadmium sulfide (CdS), or a combination thereof.

The first device region 100 may include the power distribution structure 150 provided on the second surface 110b of the first substrate 110. The power distribution structure 150 may be an integrated circuit including a power distribution network (PDN) for power distribution. The power distribution structure 150 may include a plurality of power distribution patterns 152 extending in the first direction (x direction). The plurality of power distribution patterns 152 may be arranged to have different vertical levels. The power distribution structure 150 may include a plurality of power distribution vias 153 extending in the second direction (y direction) perpendicular to the first direction (x direction). The plurality of power distribution vias 153 may be provided between the plurality of power distribution patterns 152, where the power distribution vias 153 can electrically connect power distribution patterns 152 on different vertical levels. The power distribution pattern 152 and the power distribution via 153 may include a conductive material that may include, for example, copper (Cu), gold (Au), silver (Ag), nickel (Ni), tungsten (W), aluminum (Al), or a combination thereof. In some embodiments, the power distribution pattern 152 and the power distribution via 153 may further include a barrier material to prevent the conductive material from diffusing to the outside of the power distribution pattern 152 and the power distribution via 153. The barrier material may include, for example, titanium (Ti), tantalum (Ta), titanium nitride (TiN), tantalum nitride (TaN), or a combination thereof. The power distribution pattern 152 and the power distribution via 153 of the power distribution structure 150 may be configured to transfer power to the active device 112 of the first substrate 110.

According to an embodiment, the first device region 100 may include a first back end of layer (BEOL) structure 120 disposed on the first surface 110a of the first substrate 110 and configured to route signals. The first BEOL structure 120 may be electrically connected to the active devices 112 included in the first substrate 110, where the first BEOL structure 120 can electrically connect and route signals between the active devices 112. Specifically, the first BEOL structure 120 may include a plurality of first BEOL patterns 122 configured to route signals and disposed to have different vertical levels. In addition, the first BEOL structure 120 may include first BEOL vias 123 formed between the first BEOL patterns 122 to interconnect the plurality of first BEOL patterns 122 having different vertical levels. The first BEOL patterns 122 and the first BEOL vias 123 may include a conductive material that may include, for example, copper (Cu), gold (Au), silver (Ag), nickel (Ni), tungsten (W), aluminum (Al), or a combination thereof. In some embodiments, the first BEOL patterns 122 and the first BEOL vias 123 may further include a barrier material to prevent the conductive material from diffusing to the outside of the first BEOL patterns 122 and the first BEOL vias 123. The barrier material may include, for example, titanium (Ti), tantalum (Ta), titanium nitride (TiN), tantalum nitride (TaN), or a combination thereof.

A first insulating layer 121 may include an insulating material. Examples of the insulating material may include a thermosetting resin such as an epoxy resin, a thermoplastic resin such as polyimide, or an insulating material in which these resins are impregnated into a core material such as an inorganic filler and/or glass fiber (glass cloth or glass fabric), for example, prepreg, Ajinomoto Build-up Film (ABF), FR-4, and Bismaleimide Triazine (BT), etc.

The second device region 200 on a side opposite to the first device region 100 with respect to the upper surface of the first bonding structure 130 may include the second substrate 210 including a passive device 212 therein. The second substrate 210 may be disposed on the first surface 110a of the first substrate 110 with the first BEOL structure 120 and the first bonding structure 130 disposed therebetween, and may include the passive device 212 therein. The second substrate 210 may include a semiconductor material, such as a Group IV semiconductor material, a Group III-V semiconductor material, a Group II-VI semiconductor material, or a combination thereof. The Group IV semiconductor material may include, for example, silicon (Si), germanium (Ge), or a combination thereof. The Group III-V semiconductor material may include, for example, gallium arsenide (GaAs), indium phosphide (InP), gallium phosphide (GaP), indium arsenide (InAs), indium antimony (InSb), indium gallium arsenide (InGaAs), or a combination thereof. The Group II-VI semiconductor material may include, for example, zinc telluride (ZnTe), cadmium sulfide (CdS), or a combination thereof. The passive device 212 may include at least one of a diode, a capacitor, an inductor, a resistor, an electrostatic discharge (ESD) device, an eFuse (electronic fuse), and a one-time programmable (OTP) memory device.

In various embodiments, a thickness d1 of the first substrate 110 may be less than a thickness d2 of the second substrate 210 in the second direction (y direction) perpendicular to the upper surface of the first substrate 110. The active device 112 may be provided in the first substrate 110, and the passive device 212 may be provided in the second substrate 210. At this time, the size of the passive device 212 is larger than the size of the active device 112. Accordingly, the second substrate 210 may be thicker than the first substrate 110 to include the passive device 212 therein. According to an embodiment, the first substrate 110 may include only the active device 112 without including the passive device 212. Accordingly, the first substrate 110 may be thinner than the second substrate 210. In addition, according to an embodiment, the thickness d1 of the first substrate 110 may be less than a thickness of the first bonding layer 131 of a first bonding structure 130 in the second direction (y direction). By having a small thickness, the process difficulty of forming a via through the first substrate 110 may be reduced.

The integrated circuit device 10a may include an intermediate structure 140 positioned between the first substrate 110 and the power distribution structure 150. The intermediate structure 140 may include an intermediate insulating layer 141 including an insulating material and a power via 143 formed within the intermediate insulating layer 141. The power via 143 may be aligned with the active device 112 of the first substrate 110 in the second direction (y direction). An intermediate pad 142 may be disposed between the power via 143 and the first substrate 110. The intermediate pad 142 and the power via 143 may be electrically connected, and can include a conductive material to transfer an electrical signal. The power via 143 may be configured to transfer power supplied from a power pad 161 to the active device 112.

According to an embodiment, the second device region 200 may include a second BEOL structure 220 disposed between the second substrate 210 and a second bonding structure 230 and configured to route signals. The second BEOL structure 220 may be electrically connected to the passive devices 212 included in the second substrate 210 to route signals between the passive devices 212. Specifically, the second BEOL structure 220 may include a plurality of second BEOL patterns 222 configured to route signals and disposed to have different vertical levels. In addition, the second BEOL structure 220 may include second BEOL vias 223 formed between and electrically connected to the second BEOL patterns 222 to interconnect the plurality of second BEOL patterns 222 having different vertical levels. The second BEOL pattern 222 and the second BEOL via 223 may include a conductive material that may include, for example, copper (Cu), gold (Au), silver (Ag), nickel (Ni), tungsten (W), aluminum (Al), or a combination thereof. In some embodiments, the second BEOL pattern 222 and the second BEOL via 223 may include a barrier material to prevent the conductive material from diffusing to the outside of the second BEOL pattern 222 and the second BEOL via 223. The barrier material may include, for example, titanium (Ti), tantalum (Ta), titanium nitride (TiN), tantalum nitride (TaN), or a combination thereof.

According to an embodiment, the first device region 100 may include a first bonding structure 130 disposed on the first BEOL structure 120. The first bonding structure 130 may include a first bonding layer 131 including an insulating material, where the insulating material may include silicon oxide. The second device region 200 may include a second bonding structure 230 disposed between the first bonding structure 130 and the second substrate 210. The second bonding structure 230 may include a second bonding layer 231 including an insulating material, where the insulating material may be silicon oxide. The first bonding layer 131 and the second bonding layer 231 may be combined with each other through oxide-to-oxide bonding. Specifically, an upper surface of the second bonding layer 231 may contact an upper surface of the first bonding layer 131 to form an interface between the second bonding layer 231 and the first bonding layer 131. However, the inventive concept is not necessarily limited to the above, and a bonding method may vary depending on types of the first bonding layer 131 and the second bonding layer 231. The first bonding structure 130 and the second bonding structure 230 may be positioned between the first substrate 110 and the second substrate 210.

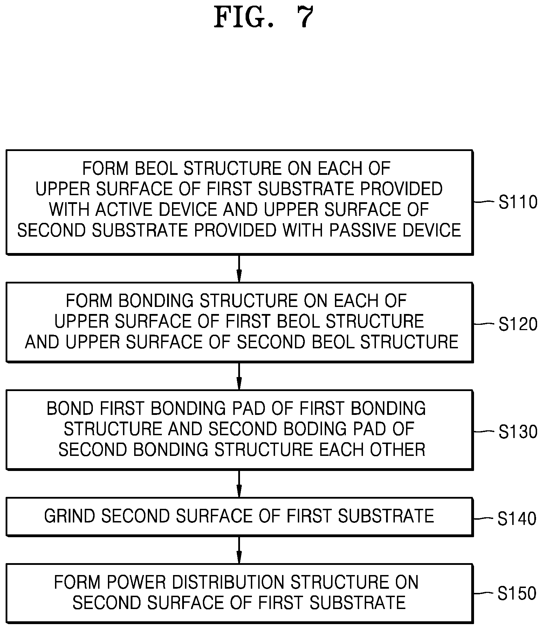

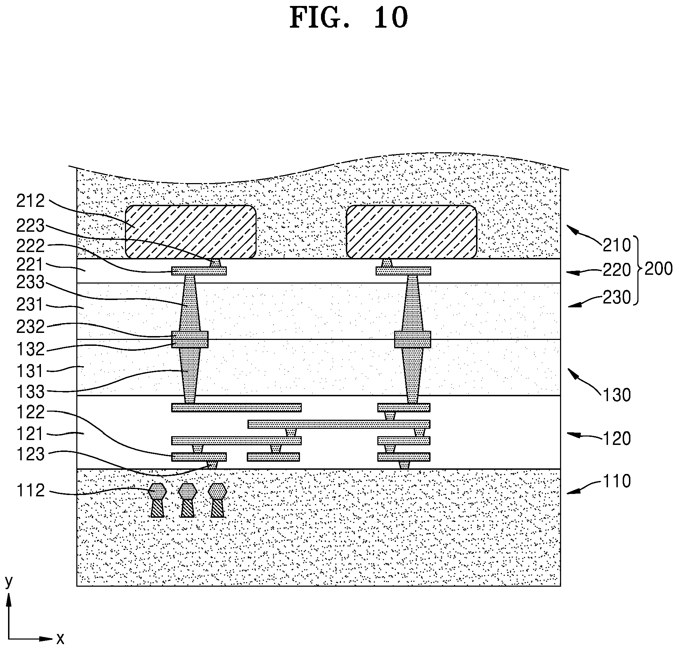

As described herein, the "upper surface" of the first bonding structure 130 contacts the "upper surface" of the second bonding structure 230. These may be considered "upper surfaces" as they relate to surfaces of the respective bonding structures furthest from the respective substrates. The "upper surface" of the first bonding structure 130 is a surface furthest from (or facing away from) the first substrate 110. The "upper surface" of the second bonding structure 230 is a surface furthest from (or facing away from) second first substrate 210. As discussed with reference to FIGs. 7 and 10, the second substrate 210 (on which the second bonding structure 230 is formed) is flipped during manufacture, to contact the upper surface of the first bonding structure 130 to the upper surface of the second bonding structure 230. In this regard, the height direction of the second device region 200 may be opposite to the height direction of the first device region 100. Conversely, instead of referring to the upper surfaces of the first bonding structure 130 and the second bonding structure 230, these surfaces may instead be referred to as "first surfaces", "external surfaces" or "interface surfaces", in that they are surfaces at an interface between the first bonding structure 130 and the second bonding structure 230. These surfaces may oppose (or face) each other.

Also, according to an embodiment, the first bonding structure 130 of the first device region 100 may include a first bonding pad 132. The first bonding pad 132 may be buried in the first bonding layer 131 and may have an exposed upper surface. The upper surface of the first bonding pad 132 may be coplanar with the upper surface of the first bonding layer 131. The second bonding structure 230 of the second device region 200 may include a second bonding pad 232. The second bonding pad 232 may be buried in the second bonding layer 231 and may have an exposed upper surface. The upper surface of the second bonding pad 232 may be coplanar with the upper surface of the second bonding layer 231. The first bonding pad 132 and the second bonding pad 232 may include a conductive material that may include, for example, copper (Cu), gold (Au), silver (Ag), nickel (Ni), tungsten (W), aluminum (Al), or a combination thereof. The upper surface of the first bonding pad 132 and the upper surface of the second bonding pad 232 may be bonded to each other. At this time, although the bonding method varies according to configuration materials of the first bonding pad 132 and the second bonding pad 232, when the first bonding pad 132 and the second bonding pad 232 include copper (Cu), the first bonding pad 132 and the second bonding pad 232 may be bonded to each other through Cu-Cu bonding. The first bonding pad 132 and the second bonding pad 232 may be aligned to overlap each other in the second direction (y direction), where the first bonding pad 132 and the second bonding pad 232 can form an electrical connection. An upper surface of the first bonding layer and an upper surface of the first bonding pad can be positioned on a same plane to be coplanar.

The first bonding structure 130 may include a first via 133 passing through the first bonding layer 131 and connected to the first BEOL structure 120, and the second bonding structure 230 may include a second via 233 passing through the second bonding layer 231 and connected to the second BEOL structure 220. The first via 133 and the second via 233 may include a metal material to transfer an electrical signal or power. The first via 133 and the second via 233 may include a conductive material that may include, for example, copper (Cu), gold (Au), silver (Ag), nickel (Ni), tungsten (W), aluminum (Al), or a combination thereof. In some embodiments, the first via 133 and the second via 233 may further include a barrier material to prevent the conductive material from diffusing to the outside of the first via 133 and the second via 233. The barrier material may include, for example, titanium (Ti), tantalum (Ta), titanium nitride (TiN), tantalum nitride (TaN), or a combination thereof. The first via 133 and the second via 233 may overlap each other in the second direction (y direction), the first via 133 may contact or may be integrally formed with the first bonding pad 132, and the second via 233 may contact or may be integrally formed with the second bonding pad 232. The first via 133 may be electrically connected to the first BEOL patterns 122, and the second via 233 may be electrically connected to the second BEOL pattern 222. The first BEOL structure 120 and the second BEOL structure 220 can form an electrical connection between the active device 112 and the passive device 212.

According to an embodiment, the first device region 100 includes a power pad 161 disposed on the second surface 110b of the first substrate 110. The power pad 161 may be disposed below the power distribution structure 150, where the power pad 161 may be on an external surface of a power distribution insulating layer 151 of the power distribution structure 150. The power pad 161 to which at least one of a power signal or a ground signal is applied may be configured to transfer power to the active device 112 provided in the first substrate 110. In addition, the first device region 100 includes a signal pad 162 disposed on the second surface 110b of the first substrate 110. The signal pad 162 may be disposed below the power distribution structure 150, where the signal pad 162 may be on an external surface of a power distribution insulating layer 151 of the power distribution structure 150. Input/output signals used for an operation of the active device 112 provided in the first substrate 110 or the passive device 212 provided in the second substrate 210 may be applied to the signal pad 162. The power pad 161 and the signal pad 162 may be electrically connected to the active device 112 or the passive device 212 through the plurality of BEOL structures 120 and 220.

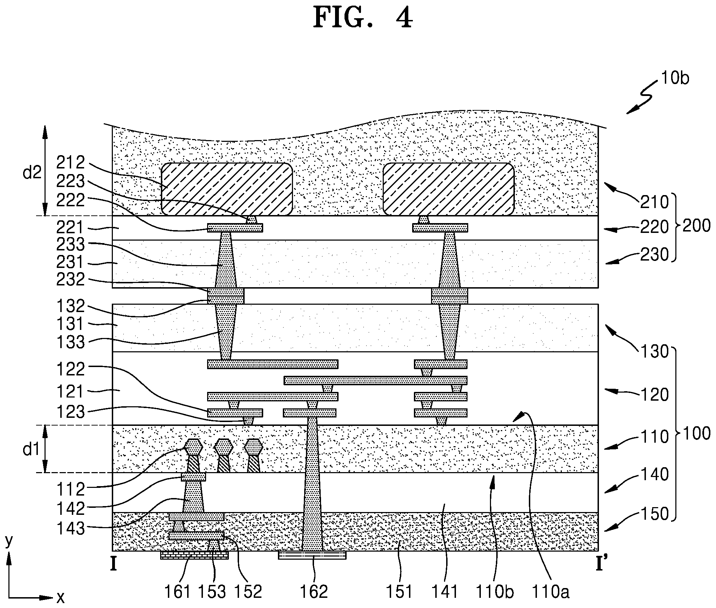

FIG. 4 is a cross-sectional view corresponding to FIG. 3 in an integrated circuit device according to another embodiment.

An integrated circuit device 10b shown in FIG. 4 is similar to the integrated circuit device 10a shown in FIG. 3 except for an arrangement of the bonding pads 132 and 232. Among the components shown in FIG. 4, descriptions of components having the same reference numerals as the components shown in FIG. 3 are omitted.

According to an embodiment, the first device region 100 may include the first bonding structure 130 disposed on the first BEOL structure 120. The first bonding structure 130 may include the first bonding layer 131 including an insulating material. The first bonding layer 131 may include silicon oxide. The second device region 200 may include a second bonding structure 230 disposed between the first bonding layer 131 and the second substrate 210. The first bonding structure 130 and the second bonding structure 230 may be positioned between the first substrate 110 and the second substrate 210.

Also, according to an embodiment, the first bonding structure 130 of the first device region 100 may include a first bonding pad 132. The first bonding pad 132 may be formed to protrude from an upper surface of the first bonding layer 131. In various embodiments, an upper surface of the first bonding pad 132 may be positioned at a higher vertical level than the upper surface of the first bonding layer 131, and a lower surface of the first bonding pad 132 may be coplanar with the upper surface of the first bonding layer 131. The second bonding structure 230 of the second device region 200 may include a second bonding pad 232. The second bonding pad 232 may be formed to protrude from the upper surface of the second bonding layer 231. The upper surface of the second bonding pad 232 may be positioned at a higher vertical level than the upper surface of the second bonding layer 231, and the lower surface of the second bonding pad 232 may be coplanar with the upper surface of the second bonding layer 231. The first bonding pad 132 and the second bonding pad 232 may include a conductive material that may include, for example, copper (Cu), gold (Au), silver (Ag), nickel (Ni), tungsten (W), aluminum (Al), or a combination thereof. The upper surface of the first bonding pad 132 and the upper surface of the second bonding pad 232 may be bonded to each other, where the first bonding pad 132 and the second bonding pad 232 can form an electrical connection. Although a bonding method varies according to configuration materials of the first bonding pad 132 and the second bonding pad 232, when the first bonding pad 132 and the second bonding pad 232 include copper (Cu), the first bonding pad 132 and the second bonding pad 232 may be bonded to each other through Cu-Cu bonding. The first bonding pad 132 and the second bonding pad 232 may be aligned to overlap each other in the second direction (y direction). The first bonding pad 132 and the second bonding pad 232 may be bonded to each other in a bonding chamber through heat and pressure applied through a rigidity press. In an embodiment, the first bonding pad 132 and the second bonding pad 232 may be bonded to each other at a temperature in a range of about 200 degrees Celsius to about 500 degrees Celsius and a force in a range of about 0.5 kilonewtons (kN) to about 100 kN. In an embodiment, the first bonding pad 132 and the second bonding pad 232 may be bonded to each other at a temperature in a range of 200 degrees Celsius to 500 degrees Celsius and a force in a range of 0.5 kilonewtons (kN) to 100 kN.

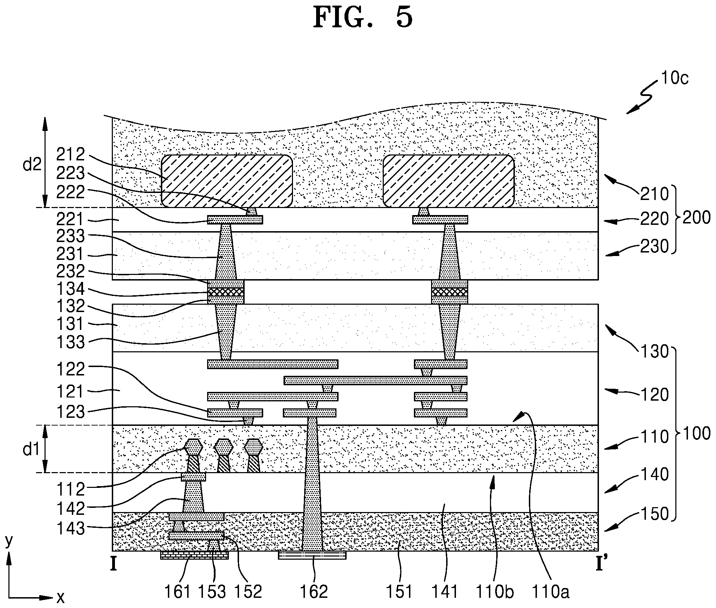

FIG. 5 is a cross-sectional view corresponding to FIG. 3 in an integrated circuit device according to another embodiment.

An integrated circuit device 10c shown in FIG. 5 is similar to the integrated circuit device 10a shown in FIG. 3 except that a metal oxide bonding layer 134 is disposed between the first bonding pad 132 and the second bonding pad 232. Among the components shown in FIG. 5, descriptions of components having the same reference numerals as the components shown in FIG. 3 are omitted.

According to an embodiment, during a bonding process, the metal oxide bonding layer 134 is formed between an upper surface of the first bonding pad 132 and an upper surface of the second bonding pad 232 by obtaining oxygen atoms from surfaces of the first bonding pad 132 and the second bonding pad 232. After such bonding, an oxygen content of each of the first bonding pad 132 and the second bonding pad 232 may be reduced compared to the first bonding pad 132 and the second bonding pad 232 before bonding. According to an embodiment, oxygen content of each of the first bonding pad 132 and the second bonding pad 232 may be reduced by 50% to 99% according to bonding process conditions.

The metal oxide bonding layer 134 may include a metal or a metal alloy and oxygen. The metal oxide bonding layer 134 may be disposed between the surfaces of the first bonding pad 132 and the second bonding pad 232, and may be aligned to the edges of the first bonding pad 132 and the second bonding pad 232. Each of an upper surface of the first bonding pad 132 and an upper surface of the second bonding pad 232 can be in physical and electrical contact with the metal oxide bonding layer. The metal oxide bonding layer 134 may have a thickness in a range of about 0.3 nm to about 100 nm (e.g. a thickness in the range of 0.3 nm to 100 nm), or a thickness of about 1 nm to about 10 nm (e.g. a thickness in the range of 1 nm to 10 nm), where the thickness of the metal oxide bonding layer 134 can depend on the amount of oxygen initially included in the first bonding pad 132 and the second bonding pad 232. In an embodiment, the metal oxide bonding layer 134 has a single layer structure. In another embodiment, the metal oxide bonding layer 134 may have a multilayer structure. When the metal oxide bonding layer 134 has a multilayer structure, respective layers of the multilayer structure may have the same composition or different compositions.

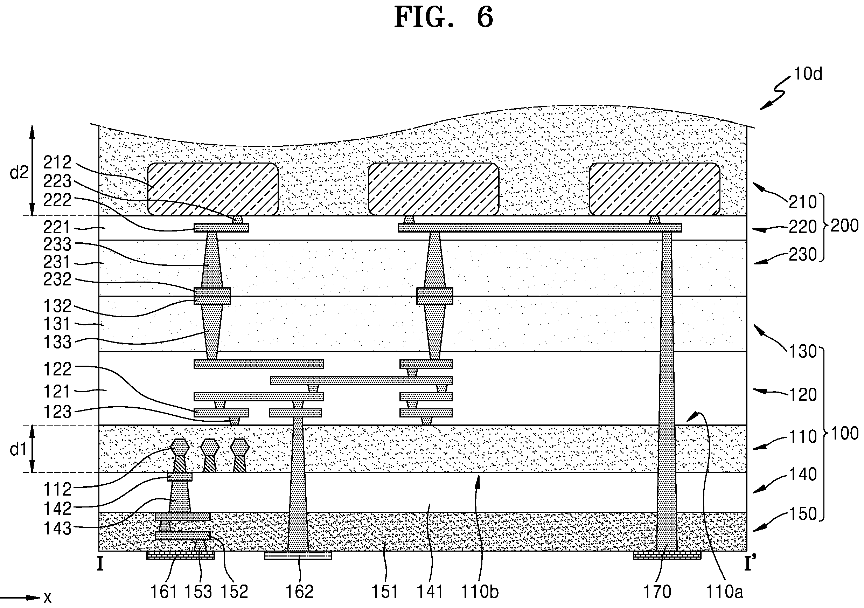

FIG. 6 is a cross-sectional view corresponding to FIG. 3 in an integrated circuit device according to another embodiment.

An integrated circuit device 10d shown in FIG. 6 is similar to the integrated circuit device 10a shown in FIG. 3 except that the integrated circuit device 10d includes a through via 170. Among the components shown in FIG. 6, descriptions of components having the same reference numerals as the components shown in FIG. 3 are omitted.

According to an embodiment, the integrated circuit device 10d may include the through via 170 that extends from the first device region 100 through the second bonding structure 230 to the second BEOL structure 220. The through via 170 may be configured to transmit an electrical signal to the second device region 200, where the through via 170 can be electrically connected to the passive device 212 by the second BEOL pattern 222 and the second BEOL via 223. The through via 170 may have a tapered shape in which a diameter thereof decreases closer to the second device region 200. The through via 170 may include a conductive material that may include, for example, copper (Cu), gold (Au), silver (Ag), nickel (Ni), tungsten (W), aluminum (Al), or a combination thereof. In some embodiments, the through via 170 may further include a barrier material to prevent the conductive material from diffusing to the outside of the through via 170. The barrier material may include, for example, titanium (Ti), tantalum (Ta), titanium nitride (TiN), tantalum nitride (TaN), or a combination thereof.

According to an embodiment, the first bonding structure 130 may include the first via 133 passing through the first bonding layer 131 and connected to the first BEOL structure 120. A length of the first via 133 in the second direction (y direction) of the first bonding structure 130 may be defined as a gap between a lower surface of the first bonding pad 132 and the first BEOL pattern 122 of the first BEOL structure 120. A length of the through via 170 may be longer than the length of the first via 133 in the second direction (y direction). Here, the second direction (y direction) may be defined as a direction perpendicular to the first surface 110a of the first substrate 110. In addition, the length of the through via 170 may be longer than a length of the first BEOL structure 120 in the second direction (y direction), where the through via 170 can extend through the first BEOL structure 120.

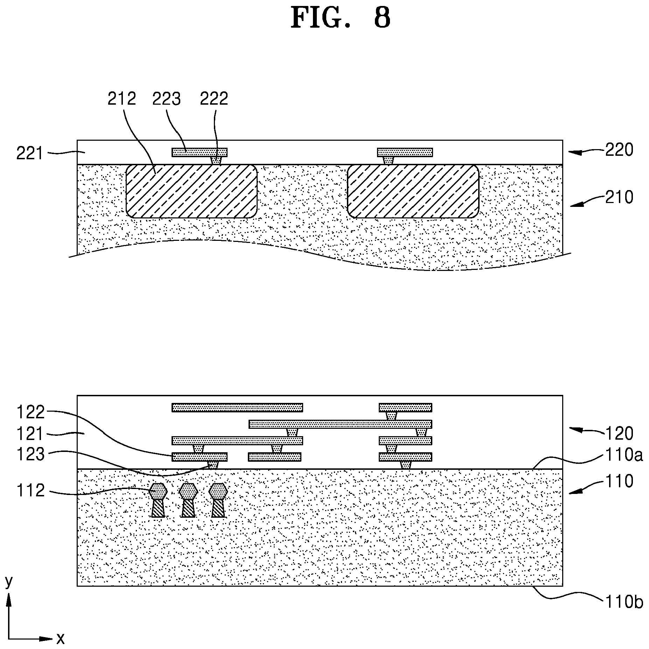

FIG. 7 is a flowchart illustrating a manufacturing process of an integrated circuit device according to an embodiment. FIGS. 8 to 13 are cross-sectional views sequentially illustrating a manufacturing process of an integrated circuit device according to an embodiment. Hereinafter, with reference to FIG. 7, an embodiment of a manufacturing process of the integrated circuit device shown in FIGS. 8 to 13 is described.

Referring to FIG. 8 together with S110 of FIG. 7, the manufacturing process of the integrated circuit device 10a according to an embodiment may include forming the first BEOL structure 120 on a first surface 110a of the first substrate 110 provided with the active device 112 and forming the second BEOL structure 220 on an upper surface of the second substrate 210 provided with the passive device 212. The method of forming the first BEOL structure 120 may include forming the first BEOL pattern 122 and the first BEOL via 123 on or in the first insulating layer 121.

In an embodiment, the first insulating layer 121 may be deposited on the first surface 110a of the first substrate 110. Deposition of the first insulating layer 121 may be performed by a process selected from among physical vapor deposition (PVD), chemical vapor deposition (CVD), and atomic layer deposition (ALD). Thereafter, the first BEOL via 123 may be formed by forming a via opening in the first insulating layer 121, and then filling the via opening with a conductive material. The first BEOL pattern 122 may be formed in the first insulating layer 121 on the first BEOL via 123.

In an embodiment, the first BEOL patterns 122 and the first BEOL vias 123 may be formed through, for example, PVD. However, according to an embodiment, a deposition method is not limited to PVD and may include a process selected from CVD and ALD. The first BEOL patterns 122 may conformally extend from an upper surface or inside of the first insulating layer 121. The first BEOL vias 123 may be formed to have a tapered shape.

The method of forming the second BEOL structure 220 may include forming the second BEOL pattern 222 and the second BEOL via 223 on or in a second insulating layer 221. A method of forming the second BEOL patterns 222 and the second BEOL vias 223 may be substantially the same as the method of forming the first BEOL patterns 122 and the first BEOL vias 123.

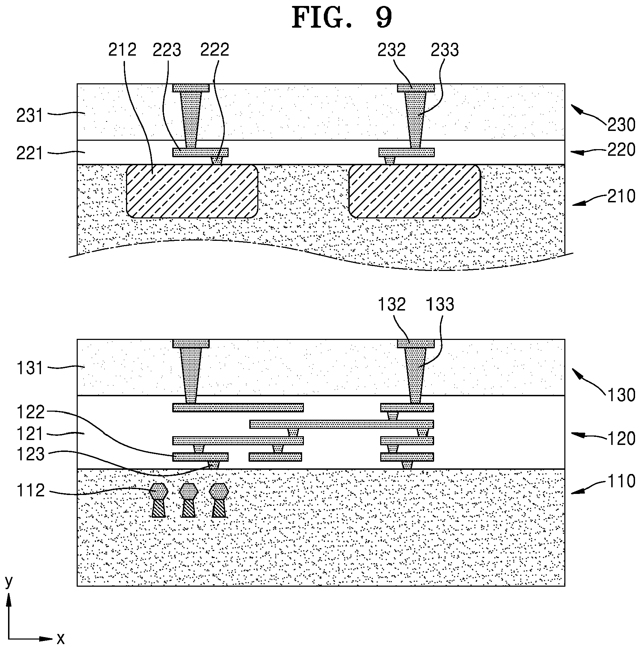

Referring to FIG. 9 together with S120 of FIG. 7, the manufacturing process of the integrated circuit device 10a according to an embodiment may include forming the first bonding structure 130 on the upper surface of the first BEOL structure 120, and forming the second bonding structure 230 on the upper surface of the second BEOL structure 220.

In an embodiment, the first bonding layer 131 may be first deposited on the upper surface of the first BEOL structure 120. Deposition of the first bonding layer 131 may be performed by a process selected from among PVD, CVD, and ALD. Thereafter, the first vias 133 may be formed by forming a via opening in the first bonding layer 131, and then filling the via opening with a conductive material. The via opening penetrating the first bonding layer 131 may be formed by, for example, mechanical drilling, laser drilling, sand blasting, dry etching, and/or wet etching. The first via 133 may have a tapered shape in which a diameter decreases closer to the first substrate 110. The first via 133 may be formed to contact the first BEOL pattern 122 of the first BEOL structure 120. The first via 133 may be formed and then, the first bonding pad 132 covering an upper surface of the first via 133 may be formed. The area of an upper surface of the first bonding pad 132 may be larger than the area of the upper surface of the first via 133.

According to an embodiment, the second bonding layer 231 may be deposited on the upper surface of the second BEOL structure 220. The second bonding layer 231 may be deposited and then, a second via 233 may be formed by forming a via opening in the second bonding layer 231, and then filling the via opening with a conductive material. The second via 233 may be formed and then, the second bonding pad 232 covering an upper surface of the second via 233 may be formed. A method of forming the second via 233 and the second bonding pad 232 may be substantially the same as the method of forming the first via 133 and the first bonding pad 132.

Referring to FIG. 10 together with S130 of FIG. 7, the manufacturing process of the integrated circuit device 10a according to an embodiment may include bonding the first bonding structure 130 and the second bonding structure 230 to each other. Specifically, the manufacturing process of the integrated circuit device 10a may include bonding the first bonding pad 132 of the first bonding structure 130 to the second bonding pad 232 of the second bonding structure 230.

According to an embodiment, the manufacturing process of the integrated circuit device 10a may include flipping (inverting) the second substrate 210 having the second bonding structure 230 formed thereon, and then aligning the first bonding pad 132 and the second substrate 210, so as to overlap each other in the second direction (y direction). Flipping (inverting) of the second substrate 210 may be performed by rotating the second substrate 210 by 180 degrees around an axis parallel with the exposed upper surface of the second bonding structure 230. The first bonding pad 132 and the second bonding pad 232 may be aligned and then bonded to each other. In this regard, a process of bonding the first bonding pad 132 and the second bonding pad 232 to each other may be performed in a temperature range of about 200 degrees Celsius to about 500 degrees Celsius (e.g. a temperature range of 200 degrees Celsius to 500 degrees Celsius).

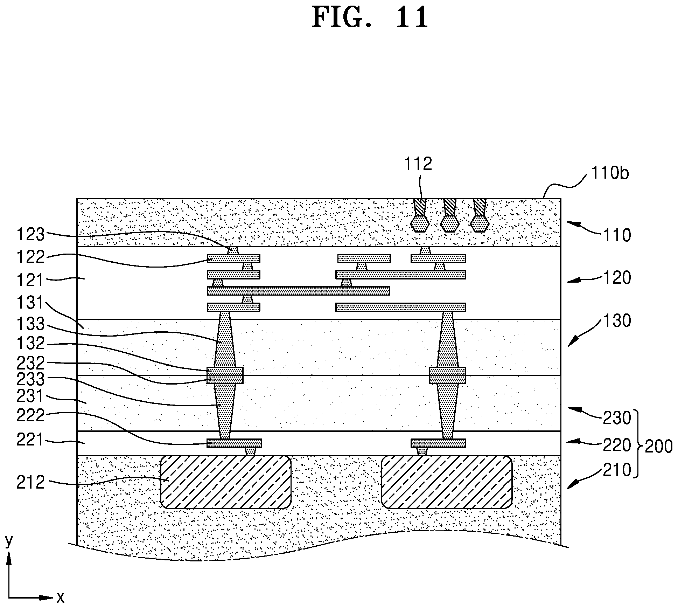

Referring to FIG. 11 together with S140 of FIG. 7, the manufacturing process of the integrated circuit device 10a according to an embodiment may include grinding the second surface 110b of the first substrate 110. When the second surface 110b of the first substrate 110 is grinded, the active device 112 provided in the first substrate 110 may not be damaged.

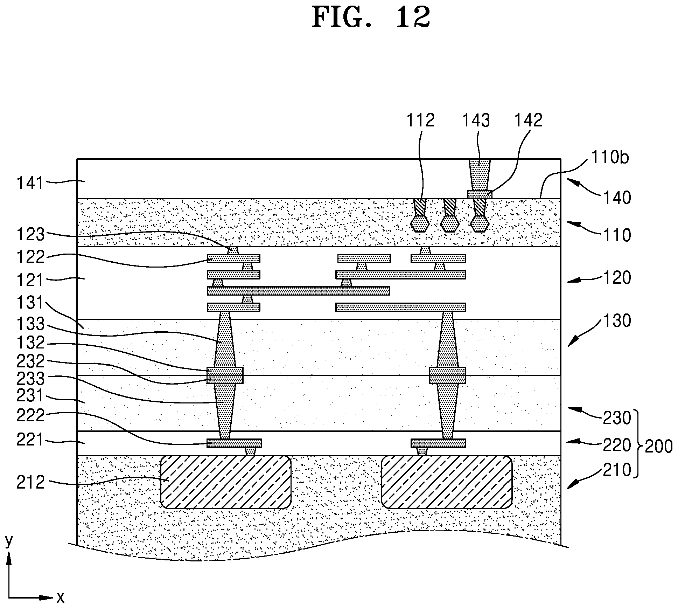

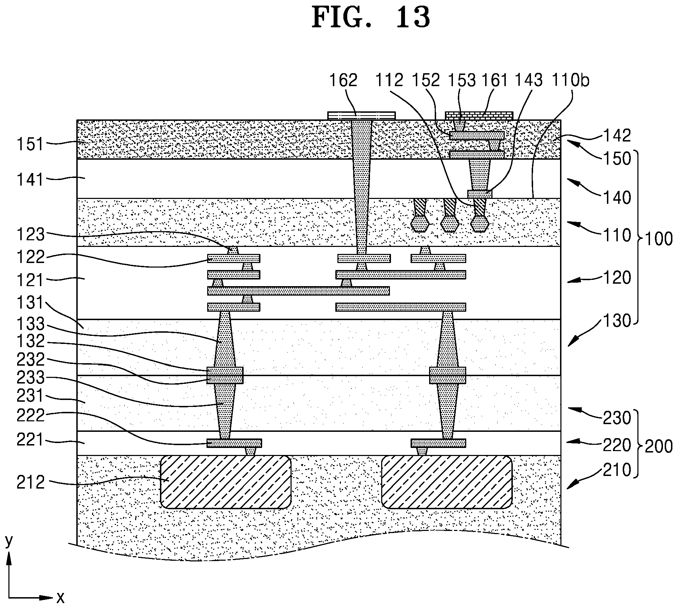

Referring to FIGS. 12 and 13 together with S150 of FIG. 7, the manufacturing process of the integrated circuit device 10a according to an embodiment may include forming the power distribution structure 150 on the second surface 110b of the first substrate 110. As shown in FIG. 12, the intermediate structure 140 may be formed before forming the power distribution structure 150 on the second surface 110b of the first substrate 110. In an embodiment, the intermediate pad 142 contacting the active device 112 provided in the first substrate 110 may be formed. The intermediate pad 142 may be configured to be electrically connected to the active device 112. Thereafter, the intermediate insulating layer 141 may be deposited on the second surface 110b of the first substrate 110 to cover the intermediate pad 142. Deposition of the intermediate insulating layer 141 may be performed by a process selected from among PVD, CVD, or ALD.

The intermediate insulating layer 141 may be formed and then, a via opening may be formed in the intermediate insulating layer 141. The via opening may be formed in the intermediate insulating layer 141, and then, the power via 143 may be formed by filling the via opening with a conductive material. The via opening penetrating the intermediate insulating layer 141 may be formed by, for example, mechanical drilling, laser drilling, sand blasting, dry etching, and/or wet etching. The power via 143 may have a tapered shape in which a diameter decreases closer to the first substrate 110. The power via 143 may be formed to contact the intermediate pad 142 of the intermediate structure 140.

The manufacturing process of the integrated circuit device 10a according to an embodiment may include forming the power distribution structure 150 on the intermediate structure 140 after forming the intermediate structure 140. To form the power distribution structure 150, a power distribution insulating layer 151 may be first deposited on the intermediate insulating layer 141 of the intermediate structure 140. The power distribution insulating layer 151 may be deposited on the intermediate structure 140 to conformally extend in the first direction (x direction). The power distribution insulating layer 151 may be formed and then, a power distribution pattern 152 may be formed on the power distribution insulating layer 151. The power distribution pattern 152 may be formed and then, an insulating material may be deposited again to cover the power distribution pattern 152. Thereafter, a via opening may be formed in the power distribution insulating layer 151, and the power distribution via 153 may be formed by filling the via opening with a conductive material. The power distribution via 153 may be aligned and formed to contact an upper surface of the power distribution pattern 152. The via opening for forming the power distribution via 153 may be formed by, for example, mechanical drilling, laser drilling, sand blasting, dry etching, and/or wet etching. The power distribution insulating layer 151, the power distribution via 153, and the power distribution pattern 152 may be formed through, for example, PVD. However, according to an embodiment, a deposition method is not limited to PVD and may include a process selected from CVD or ALD.

According to an embodiment, the manufacturing process of the integrated circuit device 10a may include forming the power pad 161 and the signal pad 162 on the power distribution structure 150 after forming the power distribution structure 150. The power pad 161 may be formed on the power distribution via 153 connected to the active device 112 among the power distribution vias 153 of the power distribution structure 150. On the other hand, the signal pad 162 may be formed on the power distribution via 153 connected to the first BEOL structure 120 on the first surface 110a of the first substrate 110. In the drawing, the power distribution via 153 connected to the first BEOL structure 120 is shown as having a through silicon via (TSV) structure, but may have various distribution shapes according to an embodiment.

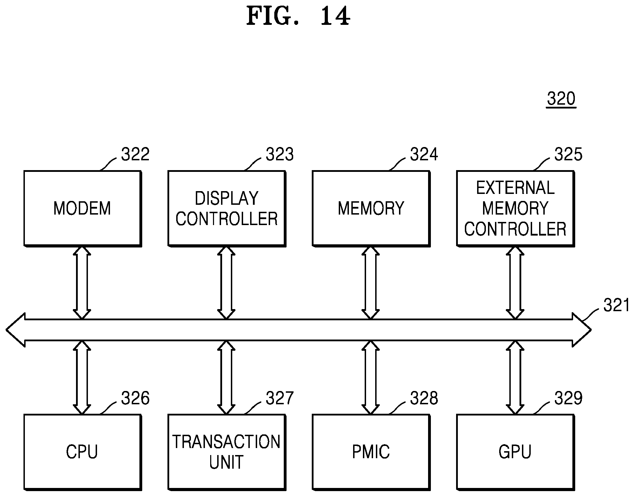

FIG. 14 is a block diagram illustrating a system on chip (SoC) according to an embodiment.

An SoC 320 is a semiconductor device and may include an integrated circuit according to an embodiment. The SoC 320 implements complex functional blocks such as intellectual property (IP) performing various functions on a single chip. A standard cell and a power rail according to an embodiment may be included in each functional block of the SoC 320, and accordingly, the SoC 320 having an improved degree of integration and an improved routing freedom may be achieved.

Referring to FIG. 14, the SoC 320 may include a modem 322, a display controller 323, a memory 324, an external memory controller 325, a central processing unit (CPU) 326, a transaction unit 327, a power management integrated circuit (PMIC) 328, and a graphic processing unit (GPU) 329, and respective functional blocks of the SoC 320 may communicate with each other through a system bus 321.

The CPU 326 capable of controlling the overall operation of the SoC 320 may control operations of the functional blocks 322 to 325 and 327 to 329. The modem 322 may demodulate a signal received from the outside the SoC 320 or modulate a signal generated from the inside the SoC 320 and transmit the signal to the outside. The external memory controller 325 may control an operation of transmitting and receiving data to and from an external memory device connected to the SoC 320. For example, programs and/or data stored in the external memory device may be provided to the CPU 326 or the GPU 329 under the control of the external memory controller 325. The GPU 329 may execute program instructions related to graphic processing. The GPU 329 may receive graphic data through the external memory controller 325 or transmit graphic data processed by the GPU 329 to the outside of the SoC 320 through the external memory controller 325. The transaction unit 327 may monitor data transactions of the respective functional blocks of the SoC 320, and the PMIC 328 may control power supplied to the respective functional blocks of the SoC 320 according to the control of the transaction unit 327. The display controller 323 may control an external display (or display device) of the SoC 320 to transmit data generated from the inside the SoC 320 to the display.

The memory 324 may include a non-volatile memory such as Electrically Erasable Programmable Read-Only Memory (EEPROM), flash memory, Phase Change Random Access Memory (PRAM), Resistance Random Access Memory (RRAM), Nano Floating Gate Memory (NFGM), Polymer Random Access Memory (PoRAM), Magnetic Random Access Memory (MRAM), Ferroelectric Random Access Memory (FRAM), etc., and may include a volatile memory such as Dynamic Random Access Memory (DRAM), Static Random Access Memory (SRAM), Mobile DRAM, Double Data Rate Synchronous Dynamic Random Access Memory (DDR SDRAM), Low Power DDR (LPDDR) SDRAM, Graphic DDR (GDDR) SDRAM, Rambus Dynamic Random Access Memory (RDRAM), etc.

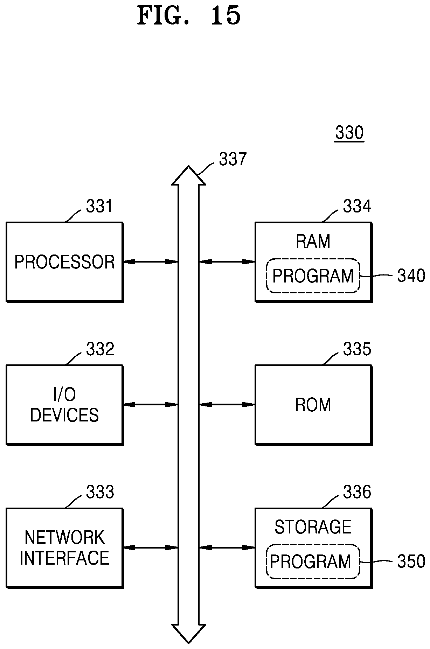

FIG. 15 is a block diagram illustrating a computing system including a memory storing a program according to an embodiment.

At least some of operations included in a method of manufacturing an integrated circuit according to an embodiment may be performed by a computing system 330.

The computing system 330 may be a fixed computing system such as a desktop computer, a workstation, or a server, or a portable computing system such as a laptop computer. As shown in FIG. 15, the computing system 330 may include a processor 331, input/output (I/O) devices 332, a network interface 333, random access memory (RAM) 334, and read only memory (ROM) 335, and a storage device 336. The processor 331, the I/O devices 332, the network interface 333, the RAM 334, the ROM 335 and the storage device 336 may be connected to a bus 337 and communicate with each other through the bus 337.

The processor 331 may be referred to as a processing unit, and may include at least one core capable of executing any instruction set (e.g., Intel Architecture-32 (IA-32), 64-bit extensions IA-32, x86-64, PowerPC, Sparc, MIPS, ARM, IA-64, etc.) such as a micro-processor, an application processor (AP), a digital signal processor (DSP), or a graphic processing unit (GPU). For example, the processor 331 may access a memory, the RAM 334 or the ROM 335, via the bus 337, and may execute instructions stored in the RAM 334 or the ROM 335.

The RAM 334 may store a program 340 or at least a part thereof for manufacturing the integrated circuit according to an embodiment. The program 340 may cause the processor 331 to perform at least one of the operations included in the manufacturing the integrated circuit.

The storage device 336 may not lose stored data even though power supplied to the computing system 330 is cut off. For example, the storage device 336 may include a non-volatile memory device or may include a storage medium such as a magnetic tape, an optical disk, or a magnetic disk. In addition, the storage device 336 may be removable from the computing system 330. The storage device 336 may store the program 350 according to an embodiment. The program 350 or at least a part thereof may be loaded to the RAM 334 from the storage device 336 before the program 350 is executed by the processor 331. Alternatively, the storage device 336 may store a file written in a program language. The program 350 generated by a compiler or at least a part thereof may be loaded to the RAM 334 from the file.

The storage device 336 may store data to be processed by the processor 331 or data processed by the processor 331. The processor 331 may generate data by processing data stored in the storage device 336 according to the program 350 and may store the generated data in the storage device 336. For example, the storage device 336 may store RTL data D10, netlist data D20, and/or layout data D30.

The I/O devices 332 may include input devices such as keyboards and pointing devices, and may include output devices such as display devices and printers.

The network interface 333 may provide access to an external network of the computing system 330. For example, a network may include multiple computing systems and communication links. The communication links may include wired links, optical links, wireless links, or any other types of links.

While the inventive concept has been particularly shown and described with reference to embodiments thereof, it will be understood that various changes in form and details may be made therein without departing from the scope of the following claims.

Further embodiments are set out in the following clauses:
1. An integrated circuit device comprising:
   a first substrate having a first surface and a second surface opposite to the first surface, and including an active device therein;
   a first back end of layer (BEOL) structure on the first surface of the first substrate and configured to route signals;
   a second substrate on the first surface of the first substrate with the first BEOL structure therebetween, and comprising a passive device therein;
   a power distribution structure on the second surface of the first substrate;
   a first bonding structure on the first BEOL structure; and
   a second bonding structure between the first bonding structure and the second substrate,
   wherein an upper surface of the second bonding structure contacts an upper surface of the first bonding structure to form an interface with the first bonding structure, and
   the second bonding structure and the first bonding structure are positioned between the first substrate and the second substrate.
2. The integrated circuit device of clause 1, wherein
   a thickness of the first substrate is less than a thickness of the second substrate in a direction perpendicular to an upper surface of the first substrate, and
   the first substrate does not include the passive device.
3. The integrated circuit device of clause 1 or claim 2, further comprising: a second BEOL structure between the second substrate and the second bonding structure and configured to route signals.
4. The integrated circuit device of clause 3, wherein
   the first bonding structure includes:
      a first bonding layer including an insulating material; and
      a first via passing through the first bonding layer and connected to the first BEOL structure,
   the second bonding structure includes,
      a second bonding layer including an insulating material; and
      a second via passing through the second bonding layer and connected to the second BEOL structure, and
   the first via and the second via vertically overlap each other.
5. The integrated circuit device of clause 3 or claim 4, further comprising: a signal pad on the second surface of the first substrate,
   wherein the signal pad is connected to the passive device through the first BEOL structure and the second BEOL structure.
6. The integrated circuit device of any preceding clause, wherein the passive device includes at least one of a vertical PNP transistor, a diode, a capacitor, an inductor, a resistor, an electrostatic discharge (ESD) device, an eFuse, or a one-time programmable (OTP) memory device.
7. The integrated circuit device of any preceding clause, wherein a thickness of the first substrate is less than a thickness of the first bonding structure in a direction perpendicular to the first surface of the first substrate.
8. The integrated circuit device of ay preceding clause, further comprising: a power pad on the second surface of the first substrate,
   wherein the power pad is configured to supply power to the active device.
9. The integrated circuit device of any preceding clause, wherein the first bonding structure includes:
   a first bonding layer including an insulating material; and
   a first bonding pad buried in the first bonding layer and having an exposed upper surface, and
   an upper surface of the first bonding layer and an upper surface of the first bonding pad are coplanar.
10. The integrated circuit device of any of clauses 1-8, wherein
   the first bonding structure includes:
      a first bonding layer including an insulating material; and a first bonding pad on an upper surface of the first bonding layer,
   the second bonding structure includes:
      a second bonding layer including an insulating material and a second bonding pad on an upper surface of the second bonding layer,
      a lower surface of the first bonding pad is coplanar with the upper surface of the first bonding layer, and
      a lower surface of the second bonding pad is coplanar with the upper surface of the second bonding layer.
11. The integrated circuit device of clause 10, wherein an upper surface of the first bonding pad contacts an upper surface of the second bonding pad.
12. The integrated circuit device of clause 10 or claim 11, further comprising:
   a metal oxide bonding layer disposed between the first bonding pad and the second bonding pad,
   wherein each of an upper surface of the first bonding pad and an upper surface of the second bonding pad contacts a metal oxide bonding layer.
13. An integrated circuit device comprising:
   a first bonding structure;
   a second bonding structure contacting an upper surface of the first bonding structure to form an interface;
   a first device region defined in one direction with respect to the upper surface; and
   a second device region defined in a direction opposite to the one direction with respect to the upper surface,
   wherein the first device region comprises:
      a first substrate having a first surface and a second surface opposite to the first surface, and comprising an active device therein;
      a first back end of layer (BEOL) structure on the first surface of the first substrate and configured to route signals;
      a power distribution structure on the second surface of the first substrate; and
      a through via passing through the first device region and the second bonding structure and configured to transfer an electrical signal to the second device region,
      wherein the second device region comprises a second substrate comprising a passive device, and
      the first substrate does not comprise the passive device.
14. The integrated circuit device of clause 13, wherein the second device region further comprises a second BEOL structure between the second substrate and the second bonding structure and configured to route signals.
15. The integrated circuit device of clause 13 or claim 14, wherein the first bonding structure includes
   a first bonding layer including an insulating material; and
   a first via passing through the first bonding layer and connected to the first BEOL structure.
16. The integrated circuit device of clause 15, wherein a length of the through via is longer than a length of the first via in a direction perpendicular to the first surface.
17. The integrated circuit device of any of clauses 13-16, wherein a thickness of the first substrate is less than a thickness of the second substrate in a direction perpendicular to the first surface.
18. The integrated circuit device of any of clauses 13-17, wherein a length of the through via is longer than a length of the first BEOL structure in a direction perpendicular to the first surface.
19. An integrated circuit device comprising:
   a first bonding structure;
   a second bonding structure contacting an upper surface of the first bonding structure to form an interface;
   a first device region defined in one direction with respect to the upper surface; and
   a second device region defined in a direction opposite to the one direction with respect to the upper surface,
   wherein the first device region comprises:
      a first substrate having a first surface and a second surface opposite to the first surface, and comprising an active device therein;
      a first back end of layer (BEOL) structure on the first surface of the first substrate, configured to route signals received from or transferred to the active device, and comprising first BEOL distribution patterns having different vertical levels and first BEOL vias between the first BEOL distribution patterns;
      a power distribution structure on the second surface of the first substrate and configured to supply power to the active device, comprising power distribution patterns having different vertical levels, and power distribution vias between the power distribution patterns; and
      a power pad below the power distribution structure and configured to supply power to the active device,
      wherein the second device region comprises a second substrate comprising a passive device therein and having a thickness smaller than a thickness of the first substrate in a direction perpendicular to an upper surface of the first substrate.
20. The integrated circuit device of clause 19, wherein
   the first bonding structure includes
      a first bonding layer including an insulating material; and
      a first bonding pad buried in the first bonding layer and having an exposed upper surface,
   wherein the second bonding structure includes
      a second bonding layer including an insulating material; and
      a second bonding pad buried in the second bonding layer and having an exposed upper surface, and
      an upper surface of the first bonding layer and an upper surface of the first bonding pad are coplanar, and an upper surface of the second bonding layer and an upper surface of the second bonding pad are coplanar.

## Claims

**1.** An integrated circuit device comprising:
a first substrate having a first surface and a second surface opposite to the first surface, and including an active device therein;
a first back end of layer, BEOL, structure on the first surface of the first substrate and configured to route signals;
a second substrate on the first surface of the first substrate with the first BEOL structure therebetween, and comprising a passive device therein;
a power distribution structure on the second surface of the first substrate;
a first bonding structure on the first BEOL structure; and
a second bonding structure between the first bonding structure and the second substrate,
wherein an upper surface of the second bonding structure contacts an upper surface of the first bonding structure to form an interface with the first bonding structure, and
the second bonding structure and the first bonding structure are positioned between the first substrate and the second substrate.

**2.** The integrated circuit device of claim 1, wherein
a thickness of the first substrate is less than a thickness of the second substrate in a direction perpendicular to an upper surface of the first substrate, and
the first substrate does not include the passive device.

**3.** The integrated circuit device of claim 1 or claim 2, further comprising a second BEOL structure between the second substrate and the second bonding structure and configured to route signals.

**3.** The integrated circuit device of claim 3, wherein
the first bonding structure includes:
a first bonding layer including an insulating material; and
a first via passing through the first bonding layer and connected to the first BEOL structure,
the second bonding structure includes:
a second bonding layer including an insulating material; and
a second via passing through the second bonding layer and connected to the second BEOL structure, and
the first via and the second via vertically overlap each other.

**5.** The integrated circuit device of claim 3 or claim 4, further comprising a signal pad on the second surface of the first substrate,
wherein the signal pad is connected to the passive device through the first BEOL structure and the second BEOL structure.

**6.** The integrated circuit device of any preceding claim, wherein the passive device includes at least one of a diode, a capacitor, an inductor, a resistor, an electrostatic discharge device, an eFuse, or a one-time programmable memory device.

**7.** The integrated circuit device of any preceding claim, wherein a thickness of the first substrate is less than a thickness of the first bonding structure in a direction perpendicular to the first surface of the first substrate.

**8.** The integrated circuit device of any preceding claim, wherein
the first bonding structure includes:
a first bonding layer including an insulating material; and
a first bonding pad buried in the first bonding layer and having an exposed upper surface, and
an upper surface of the first bonding layer and an upper surface of the first bonding pad are coplanar.

**9.** The integrated circuit device of any of claims 1-7, wherein
the first bonding structure includes:
a first bonding layer including an insulating material; and
a first bonding pad on an upper surface of the first bonding layer,
the second bonding structure includes:
a second bonding layer including an insulating material; and
a second bonding pad on an upper surface of the second bonding layer,
a lower surface of the first bonding pad is coplanar with the upper surface of the first bonding layer, and
a lower surface of the second bonding pad is coplanar with the upper surface of the second bonding layer.

**10.** The integrated circuit device of claim 9, wherein an upper surface of the first bonding pad contacts an upper surface of the second bonding pad.

**11.** The integrated circuit device of claim 9 or claim 10, further comprising:
a metal oxide bonding layer disposed between the first bonding pad and the second bonding pad,
wherein each of an upper surface of the first bonding pad and an upper surface of the second bonding pad contacts a metal oxide bonding layer.

**12.** An integrated circuit device according to any preceding claim, further comprising:
a first device region defined in one direction with respect to the upper surface of the first bonding structure; and
a second device region defined in a direction opposite to the one direction with respect to the upper surface of the first bonding structure,
wherein the first device region comprises:
the first substrate;
the first back end of layer, BEOL, structure;
the power distribution structure; and
a through via passing through the first device region and the second bonding structure and configured to transfer an electrical signal to the second device region, wherein the second device region comprises the second substrate, and
wherein the first substrate does not comprise the passive device.

**13.** The integrated circuit device of claim 12, wherein the second device region further comprises a second BEOL structure between the second substrate and the second bonding structure and configured to route signals.

**14.** The integrated circuit device of claim 12 or claim 13, wherein the first bonding structure includes
a first bonding layer including an insulating material; and
a first via passing through the first bonding layer and connected to the first BEOL structure.

**15.** An integrated circuit device according to any of claims 1-11, further comprising:
a first device region defined in one direction with respect to the upper surface of the first bonding structure; and
a second device region defined in a direction opposite to the one direction with respect to the upper surface of the first bonding structure,
wherein the first device region comprises:
the first substrate;
the first back end of layer, BEOL, structure, wherein the first BEOL structure is configured to route signals received from or transferred to the active device and comprises first BEOL distribution patterns having different vertical levels and first BEOL vias between the first BEOL distribution patterns;
the power distribution structure, wherein the power distribution structure is configured to supply power to the active device and comprises power distribution patterns having different vertical levels, and power distribution vias between the power distribution patterns; and
a power pad below the power distribution structure and configured to supply power to the active device,
wherein the second device region comprises the second substrate, wherein the second substrate has a thickness greater than a thickness of the first substrate in a direction perpendicular to an upper surface of the first substrate.
